(19) **Europäisches Patentamt / European Patent Office / Office européen des brevets**

(11) **EP 1 697 706 B1**

(12) **FASCICULE DE BREVET EUROPEEN**

(45) Date de publication et mention de la délivrance du brevet:
**01.04.2015 Bulletin 2015/14**

(51) Int Cl.:
***C01G 49/00*** (2006.01)  ***G01J 5/20*** (2006.01)
***C01G 49/08*** (2006.01)  ***C01G 51/00*** (2006.01)
***C01G 53/00*** (2006.01)  ***C23C 14/08*** (2006.01)
***H01L 27/146*** (2006.01)

(21) Numéro de dépôt: **04816549.2**

(22) Date de dépôt: **15.12.2004**

(86) Numéro de dépôt international:
**PCT/FR2004/050695**

(87) Numéro de publication internationale:
**WO 2005/064294 (14.07.2005 Gazette 2005/28)**

(54) **UTILISATION DE FERRITES SPINELLES COMME MATERIAU SENSIBLE POUR DISPOSITIFS BOLOMETRIQUES DE DETECTION DE L INFRAROUGE.**

VERWENDUNG VON SPINEL-FERRITEN ALS EMPFINDLICHES MATERIAL FÜR BOLOMETRISCHE INFRAROT-DETEKTIONSEINRICHTUNGEN

USE OF SPINEL FERRITES AS SENSITIVE MATERIAL FOR BOLOMETRIC INFRARED DETECTION DEVICES

(84) Etats contractants désignés:
**AT BE BG CH CY CZ DE DK EE ES FI FR GB GR HU IE IS IT LI LT LU MC NL PL PT RO SE SI SK TR**

(30) Priorité: **22.12.2003 FR 0315190**

(43) Date de publication de la demande:
**06.09.2006 Bulletin 2006/36**

(73) Titulaires:
- **UNIVERSITE PAUL SABATIER TOULOUSE III**
  **31062 Toulouse Cedex 4 (FR)**
- **CENTRE NATIONAL DE LA RECHERCHE SCIENTIFIQUE**
  **75794 Paris Cedex 16 (FR)**
- **Commissariat à l'Énergie Atomique et aux Énergies Alternatives**
  **75015 Paris (FR)**

(72) Inventeurs:
- **TAILHADES, Philippe**
  **F-31650 Saint-Orens de Gameville (FR)**
- **PRESMANES, Lionel**
  **F-31320 Castanet (FR)**
- **BONNINGUE, Corine**
  **F-31400 Toulouse (FR)**
- **OUVRIER-BUFFET, Jean-Louis**
  **F-74320 Sevrier (FR)**
- **ASTIER, Astrid**
  **F-38340 Voreppe (FR)**
- **CAPDEVILLE, Stéphanie**
  **F-31500 Toulouse (FR)**
- **VIALLE, Claire**
  **F-38120 Saint Egreve (FR)**
- **IMPERINETTI, Pierre**
  **F-38180 Seyssins (FR)**

(74) Mandataire: **Le Coupanec, Pascale A.M.P.**
**Cabinet Nony**
**3, rue de Penthièvre**
**75008 Paris (FR)**

(56) Documents cités:
**FR-A- 2 150 608    US-A- 5 854 587**

**EP 1 697 706 B1**

**Description**

L'invention a pour objet l'utilisation de ferrites spinelles comme matériau sensible pour dispositifs bolométriques destinés à la détection de rayonnements infrarouges.

On sait que les détecteurs bolométriques comportent un élément sensible à base d'un matériau dont la résistance électrique varie avec la température.

Les dispositifs thermiques de détection de l'infrarouge sont capables d'absorber un rayonnement infrarouge incident et de le convertir en chaleur. L'augmentation de température de l'élément sensible qui en résulte engendre une variation de la résistance dudit élément sensible. Ces dispositifs permettent donc, à l'aide d'un montage électrique approprié, connu en soi, de convertir une modification de la température en signal électrique.

Pour l'imagerie infrarouge, on utilise entre autre actuellement, comme caméras infrarouges, des microbolomètres comportant une pluralité de microcapteurs disposés sous la forme d'un réseau matriciel de pixels. Chaque microcapteur absorbe les radiations infrarouges qui le frappent, et les variations résultantes de température du matériau sensible, présent sous forme de couche mince dans chaque microcapteur, induisent une variation de la résistance électrique dudit matériau sensible. Un système de mesure, connu en soi, évalue les variations de la résistance et les traduit en signaux électriques. Ces signaux électriques peuvent être convertis en images à l'aide d'un dispositif d'imagerie approprié, connu en soi.

On connaît des systèmes de détection et d'imagerie infrarouge ayant une bonne sensibilité, qui utilisent des matériaux sensibles à base de « HgCdTe » ou « YBaCuO ». Toutefois, ces systèmes présentent l'inconvénient de devoir être refroidis à la température de l'azote liquide.

Il existe aussi des dispositifs bolométriques "non refroidis", dont le fonctionnement est basé notamment sur les variations de propriétés électriques du silicium amorphe ou de l'oxyde de vanadium. Ces dispositifs sont toutefois moins sensibles que les dispositifs refroidis.

Des matériaux à base de perovskites ont également été préconisés. Ils présentent une sensibilité potentiellement intéressante, mais qui est contrebalancée par un bruit électronique intense.

Il existe donc actuellement un besoin d'obtenir des dispositifs bolométriques non refroidis de détection de l'infrarouge ayant une bonne sensibilité et permettant une minimisation du bruit électronique.

On a maintenant découvert que certains oxydes spinelles de métaux de transition, à base de fer, sont utilisables sous forme de couches minces comme matériau sensible pour des dispositifs bolométriques de détection de l'infrarouge. Ces matériaux, qui sont des ferrites spinelles, possèdent une résistivité électrique modérée et très sensible à la température. Ils permettent donc de faire des mesures électriques à fort rapport signal/bruit, et leur sensibilité peut être mise à profit pour déceler des rayonnements infrarouges de faible intensité, notamment dans la bande de longueurs d'onde de 8 à 12 micromètres.

L'utilisation d'oxydes de structure spinelle dont le manganèse est l'élément majoritaire comme thermistances et non comme détecteurs d'infrarouge a été décrite dans les demandes de brevet JP 2000-348905 A2 et EP 1 058 276 A2. Toutefois, ces oxydes sont des manganites et à ce titre différent des ferrites. Pour sa part l'article de A. Doctor, S. Baliga, M. Rost « Sputtered films thermistor IR detector » Proc. IEEE Mohawk Valley Dual-Use Technology and Applied Conférence, 153-156, 1993, propose des détecteurs bolométriques pour l'infrarouge utilisant des couches minces d'oxydes spinelles à base de nickel, de cobalt et de manganèse. Cet article décrit un mode de réalisation et d'utilisation de tels détecteurs IR en couches minces. Le brevet US 5 854 587 décrit l'utilisation de manganites de type perovskites comme matériau sensible pour bolomètres.

Quant au document FR 2 150 608, il décrit l'utilisation, dans des dispositifs bolométriques refroidis, de matériaux de la classe des ferrites et des oxydes de fer en tant que capteurs de rayonnement infrarouge (c'est-à-dire en tant que matériaux capables d'absorber un rayonnement infrarouges et de le convertir en chaleur avec une bon rendement).

L'invention concerne donc, selon un de ses aspects, l'utilisation comme matériau sensible en couche mince pour la détection bolométrique de radiations infrarouges, d'un matériau ayant une structure de ferrite spinelle dont la composition chimique, en dehors d'agents dopants éventuellement présents, répond à la formule brute I:

$$Fe_{3-(x+y)} M_x A_y O_{4+\delta} \qquad (I)$$

dans laquelle le fer est l'élément métallique majoritaire,
M représente un métal ou une combinaison de deux ou plusieurs métaux de transition autre(s) que le fer,
A représente au moins un métal choisi parmi le magnésium et l'aluminium,
les métaux et l'oxygène sont sous forme d'ions,
x représente le nombre d'ions métalliques M, identiques ou différents,
y représente le nombre d'ions métalliques,
x peut varier de 0 à 2, et quelque soit x, x < 3-x-y
y peut varier de 0 à 0,5,

et

δ représente 0 ou un nombre positif, de valeur telle ou encore suffisamment faible pour que le produit de formule I contienne au moins un métal présent sous forme d'ions ayant deux états d'oxydation différents et situés sur un même sous-réseau de la structure spinelle.

Autrement dit, les produits de formule I, avec δ différent de zéro, sont des produits d'oxydation partielle, et non totale, des ferrites spinelles pour lesquels δ = 0, appelés ferrites spinelles stoechiométriques. Les raisons de cette caractéristique d'oxydation seulement partielle apparaîtront dans la suite de la description.

La présente invention concerne en outre, selon un autre de ses aspects, un dispositif bolométrique pour la détection d'un rayonnement infrarouge ou pour l'imagerie infrarouge, comprenant au moins un capteur muni d'un élément sensible ayant la forme d'une couche mince d'un matériau ayant une structure de ferrite spinelle conforme à la présente invention.

Elle se rapporte également, selon un autre de ses aspects, à un procédé de détection d'un rayonnement infrarouge ou de production d'imagerie infrarouge, à l'aide d'un dispositif bolométrique capable d'absorber un rayonnement incident, de le convertir en chaleur, et de communiquer une partie de la chaleur produite à un élément sensible dont la résistivité varie avec la température, dans lequel ledit dispositif est tel que défini ci-après.

## Description de l'invention

On sait que les oxydes de fer sont des composés ioniques, les métaux étant sous forme de cations, et l'oxygène sous forme d'anions $Q^{2-}$.

Dans la formule I selon l'invention, Fe représente l'ensemble des cations fer (ferreux et ferriques).

Dans cette même formule, M figure un métal autre que le fer ou une combinaison de deux ou plusieurs métaux autres que le fer.

En d'autres termes, M peut être symbolisé dans la formule générale I par la séquence $M_{x0}M'_{x1}M''_{x2}$ dans laquelle M, M', M'' ... représentent des métaux de transition autres que le fer, et les indices $x_0$, $x_1$ et $x_2$ représentent le nombre d'ions M, M', M''...

M étant choisi parmi Co, Cu, Mn, Ni, Zn et Ti ou une de leurs combinaisons.

On citera en particulier les ferrites de formule I dans lesquels M est un métal choisi parmi Co, Cu, Mn, Zn, Ni et Ti y compris ceux pour lesquels y est égal à zéro ou une de leurs combinaisons.

On rappelle ci-après quelques propriétés connues des oxydes spinelles de métaux de transition, en prenant le cas des ferrites spinelles.

On sait que la structure du spinelle ($MgAl_2O_4$) est également celle de la magnétite $Fe_3O_4$. On sait aussi que l'oxydation de la magnétite conduit au sesquioxyde de fer $Fe_2O_3$, qui conserve la structure cristalline de la magnétite, sous la forme dite $\gamma$-$Fe_2O_3$, jusqu'à une température de 400-500 °C environ, à laquelle l'oxyde $\gamma$-$Fe_2O_3$ se transforme en $\alpha$-$Fe_2O_3$, ce dernier ayant la structure du corindon.

On sait également que la structure de $\gamma$-$Fe_2O_3$, qui est obtenue par oxydation de la magnétite, est une structure de spinelle lacunaire. En effet, lors de l'oxydation de $Fe_3O_4$, le réseau d'anions $O^{2-}$ reste immuable. Des ions oxygène négatifs sont absorbés à la surface de l'oxyde. Ils s'arrangent selon une organisation identique à celle existant dans le réseau de la magnétite, dont ils constituent une extension. Les charges négatives ainsi apportées sont compensées par l'oxydation des ions ferreux en ions ferriques qui migrent, depuis l'intérieur du cristal, vers le nouvel arrangement d'anions oxygène dont ils assurent la cohésion en établissant des liaisons entre les cations $Fe^{3+}$ et les anions $O^{2-}$. Au terme de l'oxydation, la structure de type spinelle est conservée. Toutefois, le rapport cations/anions, initialement égal à 3/4, est devenu plus petit compte tenu de l'apport d'anions oxygène. Le cristal du produit oxydé comporte alors des sites normalement occupés par des ions métalliques (dans l'oxyde $Fe_3O_4$), qui sont devenus vacants, car abandonnés par les cations ayant migré à la surface. Ces sites sont encore appelés lacunes.

Les ferrites spinelles dits stoechiométriques du type $X_aFe_{3-a}O_4$, où X représente au moins un métal divalent et a <1, peuvent, tout comme la magnétite, être transformés en oxydes spinelles lacunaires, notamment par oxydation.

Il est connu, en outre, qu'en introduisant dans les ferrites spinelles divers substituants, et notamment des métaux ayant des états de valence multiples, il est possible de créer des lacunes ou d'en faire varier le nombre.

Par exemple, le remplacement d'une partie des ions $Fe^{2+}$ par des ions trivalents, sans modifier le nombre de charges cationiques équilibrant les charges anioniques du réseau d'ions oxygène, peut se faire en remplaçant trois ions $Fe^{2+}$ par deux ions trivalents. Il y a donc dans ce cas remplacement de trois cations fer par deux ions seulement, et donc création d'une lacune.

Inversement, si on remplace des ions $Fe^{3+}$ par des ions divalents, la seule possibilité, pour conserver le nombre de charges cationiques, est de remplacer deux cations $Fe^{3+}$ par trois cations divalents, à condition de pouvoir utiliser une lacune déjà présente dans le réseau. Ainsi, le remplacement de $Fe^{3+}$ par un cation divalent conduit à une diminution du nombre de lacunes.

On appelle « ferrites spinelles lacunaires déficients en cations » (ou ferrites spinelles sur-stoechiométriques) des composés du type spinelle à base de $\gamma$-Fe$_2$O$_3$ modifié par remplacement d'une partie des ions ferriques, et éventuellement des lacunes, par des cations métalliques autres que ferriques. Pour représenter les oxydes spinelles lacunaires sur-stoechiométriques, en gardant, dans la formule, un nombre d'atomes métalliques égal à trois (comme dans la formule Fe$_3$O$_4$), on est amené à écrire leur formule sous une forme du type X$_x$ Fe$_{3-x}$ O$_{4+\delta}$, où Fe représente l'ion fer trivalent, X représente au moins un cation métallique autre que le cation ferrique, x est le nombre de cations X, tel que la somme du nombre de cations X et du nombre de cations ferriques est égale à 3, O représente un anion O$^{2-}$, et $\delta$ est un nombre positif.

Une autre façon de représenter les oxydes spinelles lacunaires surstoechiométriques, en gardant cette fois un nombre d'atomes d'oxygène égal à 4 (comme dans la formule Fe$_3$O$_4$), est d'écrire sa formule sous une forme équivalente faisant mention des lacunes :

$$X_x \, Fe_{3-x-y} \, \square_y \, O_4$$

dans laquelle le symbole $\square$ représente les lacunes.

Ainsi, les ferrites spinelles stoechiométriques et les ferrites spinelles modérément lacunaires (incomplètement oxydés), comprennent, sous forme d'oxydes, au moins un même métal présent sous la forme de deux cations ayant des états d'ionisation différents. Ce sont donc des produits oxydables, cette oxydation se faisant avec formation de lacunes.

Dans les formules précédentes, la valeur du nombre représenté par $\delta$ dépend de la nature des métaux présents et des conditions du traitement d'oxydation. En fait, le nombre $\delta$ correspond au nombre d'anions O$^{2-}$, en plus de 4, qui est nécessaire pour compenser l'augmentation des charges des différents cations ayant été oxydés, afin d'assurer le maintien de la neutralité électrique. La détermination de $\delta$ (ou, ce qui revient au même, du nombre de lacunes) ne présente aucun intérêt en pratique. En fait, la mention de $\delta$ dans l'expression du nombre d'atomes oxygène de la formule brute I a surtout une valeur d'information qualitative, car elle permet de comprendre immédiatement que, lorsque $\delta$ n'est pas nul, la formule brute I représente un ferrite spinelle lacunaire. Dans les ferrites lacunaires de formule I, le nombre $\delta$ est généralement inférieur à 0,8 plus particulièrement inférieur à 0,5 environ et qualifie donc des ferrites lacunaires.

L'obtention d'une couche mince du matériau sensible selon l'invention, sur un substrat approprié, peut être effectuée selon les techniques usuelles, notamment par pulvérisation cathodique, au départ d'une cible obtenue de façon classique par frittage d'un mélange de poudres d'oxydes des divers métaux choisis, et éventuellement d'agents dopants (ces derniers étant éventuellement sous forme d'oxydes).

La technique de pulvérisation cathodique est un procédé de dépôt sur un substrat de couches minces d'un matériau quelconque, dans une enceinte contenant un gaz inerte, généralement de l'argon maintenu à pression réduite. Sous l'influence d'un champ électrique, le gaz est ionisé avec formation d'un plasma luminescent, et le choc des ions incidents sur le matériau, appelé « matériau-cible » ou « cible », qui est fixé sur une électrode soumise à un potentiel cathodique, provoque, par un effet mécanique, l'expulsion d'atomes de surface du matériau qui vont se déposer sur le substrat placé en face de la cible. En général, la composition du dépôt est voisine de la composition du matériau-cible.

L'utilisation de tensions alternatives, en particulier à haute fréquence, présente divers avantages, notamment la pulvérisation de matériaux isolants et la possibilité d'utiliser des tensions d'amorçage plus faibles qu'en courant continu. Un tel procédé est appelé pulvérisation cathodique en radiofréquence (ou pulvérisation cathodique RF).

Par superposition au champ électrique d'un champ magnétique au voisinage de la cathode (utilisation d'une cathode magnétron), on peut compliquer les trajectoires des électrons du plasma et augmenter ainsi l'ionisation du gaz, ce qui permet notamment d'obtenir une vitesse de dépôt plus importante pour une même puissance appliquée.

Lorsque l'on souhaite déposer des oxydes métalliques en évitant le dépôt de formes totalement ou fortement oxydées, il est possible d'opérer avec de faibles pressions d'argon, par exemple 0.5 Pa. Inversement, si l'on souhaite obtenir un dépôt d'une forme oxydée, on peut opérer en présence d'un mélange d'argon et d'oxygène.

Le dépôt peut aussi être effectué par les autres techniques connues d'élaboration en phase vapeur, comme par exemple l'évaporation sous vide, ou l'ablation laser.

Les couches minces de ferrites spinelles utilisées selon l'invention sont des couches polycristallines.

De préférence, la couche mince déposée a une composition proche du ferrite stoechiométrique (correspondant à $\delta$ = 0 ou voisin de 0). En déposant un matériau ayant sensiblement la composition du ferrite stoechiométrique, en atmosphère non oxydante, on obtient en effet des couches minces possédant la structure spinelle dont l'état cristallin est davantage satisfaisant que lorsque l'on dépose un ferrite plus oxydé ayant la composition souhaitée pour le produit final. En particulier, le dépôt sous forme de ferrite sensiblement stoechiométrique permet d'obtenir une couche mince de ferrite dont les dimensions des cristallites sont satisfaisantes. Il est ainsi possible d'obtenir des couches minces, d'épaisseur allant de 10 à 500 nm, et en particulier de 50 à 150 nm, constituées de cristallites dont la taille moyenne varie entre 5 et 50 nm environ, et en particulier entre 10 et 30 nm environ. Ces caractéristiques dimensionnelles, grâce à la faible épaisseur de la couche, permettent en effet de minimiser l'inertie thermique de la couche sensible et, grâce à la faible taille des cristallites, de minimiser la dispersion du bruit électronique d'un pixel à l'autre, lors de la détection bolométrique. Par exemple, en effectuant le dépôt par pulvérisation cathodique radiofréquence, sous une pression d'argon pouvant aller de 0,1 à 2,5 Pa, il est possible d'obtenir des compositions de ferrites présentant les caractéristiques qui viennent d'être indiquées.

On appelle « cristallites » les microcristaux constituant la couche mince. Ce sont des domaines cristallins qui diffractent de manière cohérente les rayons X. Autrement dit, ce sont des monocristaux dont les dimensions moyennes peuvent être facilement déterminées, notamment par microscopie électronique à transmission, microscopie à force atomique ou par diffraction des rayons X.

D'une façon générale, les compositions de ferrites spinelles lacunaires peuvent être modifiées par des agents dopants, qui ne sont pas représentés par la formule I, et qui ne font pas nécessairement partie du réseau cristallin. L'utilisation d'un grand nombre d'agents dopants a été décrite pour ce type de composés. La présence d'agents dopants peut par exemple faciliter la régulation de la cristallisation. Généralement, les agents dopants sont présents sous forme d'oxydes dans une proportion pondérale ne dépassant pas 1 à 2 % en poids, par rapport au poids de l'oxyde spinelle. Les agents dopants sont par exemple le silicium, le phosphore, le bore, des métaux alcalino-terreux (en particulier Ca, Ba, Sr), des métaux alcalins (par exemple Na, K, Li), le gallium, le germanium, l'arsenic, l'indium, l'antimoine, le bismuth, le plomb, etc.

Lors du dépôt de mélanges d'oxydes ayant sensiblement la composition d'oxydes spinelles de type stoechiométrique, dépôt éventuellement suivi d'un traitement thermique en atmosphère oxydante, la couche mince déposée adopte spontanément une structure cristalline de spinelle.

Après le dépôt de la couche mince ayant sensiblement la composition d'un oxyde spinelle de type stoechiométrique, il convient généralement d'effectuer un traitement d'oxydation pour faire apparaître des lacunes. La faible épaisseur des couches déposées ainsi que la faible taille des cristallites facilitent une oxydation à une température modérée, généralement inférieure ou égale à 300 °C. Lors de ce traitement d'oxydation, la couche mince acquiert la structure de spinelle lacunaire, et on constate que ce traitement d'oxydation permet généralement d'augmenter la variation de la résistivité avec la température, qui représente la propriété de sensibilité recherchée pour les matériaux actifs des dispositifs bolométriques.

Les ferrites spinelles stoechiométriques ou lacunaires utilisés selon l'invention ont des propriétés de semi-conducteurs. En effet, leur conductivité augmente avec la température : ce sont des produits dits à coefficient de température négatif. De tels produits sont caractérisés par leur énergie d'activation, Ea, calculée selon la formule

$$Ea* = k\,B,$$

avec

k représentant la constante de Boltzman et

B la constante énergétique, qui correspond à la pente de la courbe représentant Log R en fonction de 1/T avec R désignant la résistance électrique et T la température.

En particulier, l'énergie d'activation Ea peut être calculée à partir de deux mesures de résistance, R1 et R2, effectuées respectivement aux températures T1 et T2 :

$$Ea = k\,\frac{T_1.T_2}{T2\text{-}T1}\,\log\!\left(\frac{R1}{R2}\right)$$

On exprime la sensibilité d'un matériau pour détecteur bolométrique à l'aide du coefficient de température $\alpha$ qui représente la dérivée de la résistance par rapport à la température, divisée par la résistance :

$$\alpha = \frac{dR}{dT}\cdot\frac{1}{R}.100 = -\frac{Ea}{k.T^2}.100$$

Le coefficient $\alpha$ est exprimé en %.Kelvin$^{-1}$ (%.K$^{-1}$).

Il est admis actuellement que la conduction électronique dans les oxydes de métaux de transition n'est possible qu'entre cations d'un même élément possédant des états d'ionisation différant d'une unité et placés sur un même sous-réseau de la structure spinelle (loi de Verwey). La conduction se fait par un mécanisme de transition par sauts, désigné en langue anglaise par le terme « hopping ».

L'oxydation des ferrites spinelles stoechiométriques en ferrites spinelles lacunaires abaisse le nombre de couples de cations (notamment couples $Fe^{2+}$-$Fe^{3+}$) permettant le phénomène de *hopping* et augmente donc la résistivité du matériau. Par exemple, dans le cas de l'oxydation totale de la magnétite, le produit obtenu, c'est-à-dire $\gamma$-$Fe_2O_3$, est totalement isolant. Il convient donc d'éviter une oxydation totale du ferrite spinelle, qui rendrait le matériau non conducteur, en jouant sur les facteurs suivants :

- durée du traitement thermique oxydant, à une température généralement inférieure à 350 °C, et en particulier inférieure ou égale à 300 °C,
- pression partielle d'oxygène.

On peut notamment opérer à l'air, la durée de traitement pouvant aller par exemple de 30 minutes à 3 heures.

Il faut évidemment éviter une oxydation totale qui augmente trop fortement la résistance, le matériau n'étant alors plus conducteur, comme on vient de le voir.

On constate que le traitement d'oxydation augmente la résistivité mais généralement augmente aussi le coefficient de température $\alpha$. On peut donc déterminer par de simples expériences de routine les conditions du traitement d'oxydation qui permettent éventuellement d'obtenir, pour une composition en métaux donnée, les degrés d'oxydation donnant une valeur optimale du coefficient $\alpha$, ou une valeur de $\alpha$ supérieure, en valeur absolue, à une valeur seuil prédéterminée (par exemple > 1 %.K$^{-1}$). De la même façon, on peut sélectionner, avec de telles expériences de routine, des compositions de métaux de transition qui permettent d'obtenir des propriétés de résistivité intéressantes, ou d'optimiser les proportions relatives des métaux de telles compositions.

Dans une phase de recherche, le procédé d'obtention d'une couche sensible de ferrite spinelle selon l'invention consiste donc à déposer une couche ayant sensiblement une composition de ferrite spinelle stoechiométrique, et à effectuer si nécessaire des traitements d'oxydation permettant éventuellement d'améliorer la valeur de $\alpha$, afin de sélectionner les compositions dont la valeur absolue de $\alpha$ est, par exemple, supérieure à 1 %.K$^{-1}$ ou à une autre valeur souhaitée tout en conservant une résistivité et un bruit électronique faibles. La couche mince est généralement déposée sur une ou plusieurs couches aptes à assurer la rigidité mécanique, l'absorption du rayonnement infrarouge et les connexions électriques de la couche sensible. Cette couche mince ou l'ensemble des couches peut (peuvent) être déposée(s) sur une structure sacrificielle.

Comme précisé précédemment, un autre aspect de l'invention concerne un dispositif bolométrique pour la détection d'un rayonnement infrarouge ou pour l'imagerie infrarouge, comprenant au moins un capteur muni d'un élément sensible ayant la forme d'une couche mince de matériau telle que définie précédemment

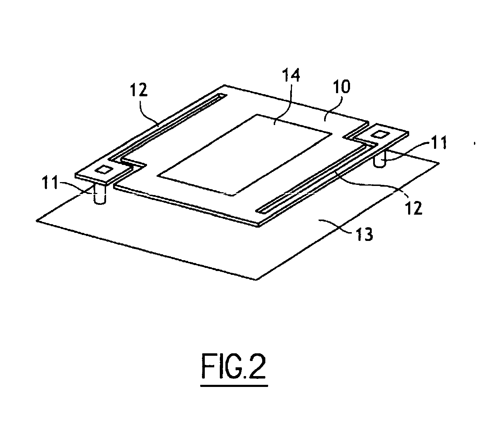

Dans un mode de réalisation particulier du dispositif bolométrique de l'invention, le capteur, qui est inséré dans un boîtier comportant une fenêtre d'entrée transparente à l'infrarouge, comprend une membrane capable d'absorber un rayonnement infrarouge et de le convertir en chaleur, ladite membrane étant disposée de façon à pouvoir être exposée à un rayonnement infrarouge incident ayant traversé la fenêtre d'entrée, et de façon à transmettre une partie de la chaleur ainsi produite audit élément sensible. En figure 2 est représentée une vue simplifiée d'un tel dispositif.

Le dispositif bolométrique qui y est représenté comprend une fine membrane 10 capable d'absorber le rayonnement infrarouge, et suspendue au-dessus d'un support 13 par l'intermédiaire de points d'ancrage 11. Une couche sensible 14 est déposée sur la membrane 10. Sous l'effet d'un rayonnement infrarouge, la membrane s'échauffe et transmet sa température à la couche 14. L'interconnexion électrique entre la couche sensible 14 et les éléments de lecture (non représentés) disposés sur le substrat est assurée par une couche, généralement métallique, non représentée, passant par les points d'ancrage 11. La sensibilité de la détection thermique est notablement améliorée en introduisant des bras d'isolement 12 entre le substrat support et la membrane afin de limiter les pertes thermiques de cette dernière. Les variations de résistivité de la couche sensible sont enregistrées à l'aide de deux électrodes reliées à un circuit de lecture approprié. Les électrodes peuvent être soit coplanaires, soit en regard (sandwich).

Dans les dispositifs bolométriques selon l'invention, le substrat support peut être constitué d'un circuit électronique intégré sur une plaquette de silicium comprenant d'une part des dispositifs de stimuli et de lecture des variations de températures et d'autre part les composants de multiplexage qui permettent de sérialiser les signaux issus des différents thermomètres et de les transmettre vers un nombre réduit de sorties afin d'être exploités par un système d'imagerie usuel.

En ce qui concerne la membrane sur laquelle est déposée la couche mince de matériau selon l'invention, elle peut être constituée par exemple d'une ou plusieurs couche(s) diélectrique(s) notamment de SiO, SiN.

Dans le cas d'une unique couche, celle-ci peut être recouverte partiellement par des électrodes notamment de TiN possédant une forte absorption du rayonnement infrarouge. Dans le cas de deux couches, les électrodes peuvent être soit apposées en surface de la couche externe soit enfermées entre les deux couches.

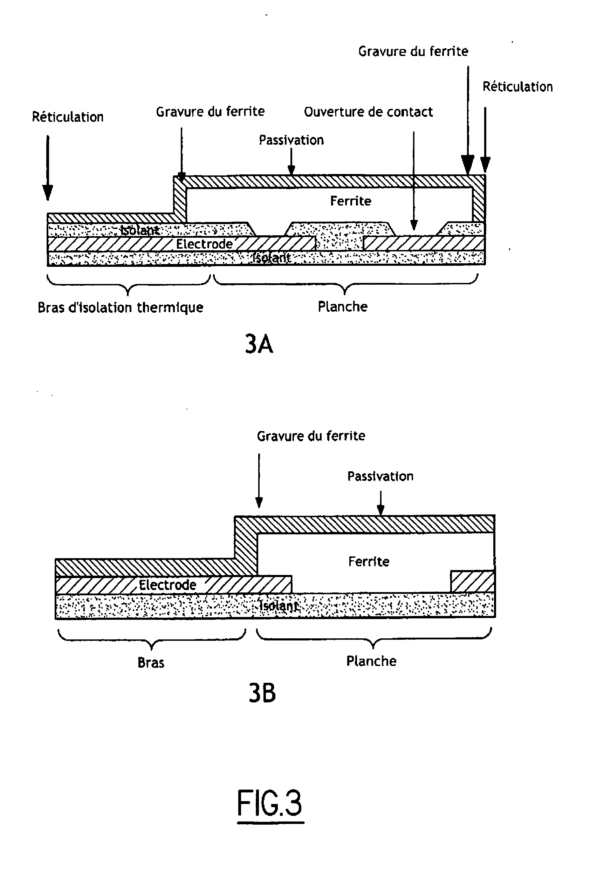

La figure 3 rend compte de deux variantes d'intégration d'une couche mince de matériau selon l'invention dans un détecteur à électrodes coplanaires.

En figure 3A, la structure supportant le ferrite est constituée de deux couches isolantes enfermant des électrodes métalliques. La couche isolante déposée sur la couche métallique comporte des ouvertures de contact de manière à connecter l'élément sensible en ferrite.

En figure 3B, la structure supportant la ferrite est constitué d'une unique couche isolante sur laquelle reposent des électrodes métalliques directement en contact avec l'élément sensible en ferrite. Dans cette configuration, il peut être intéressant de déposer une couche absorbante le rayonnement infrarouge sur l'une des faces de la structure.

Dans ces deux variantes de réalisation, la gravure de la ferrite permet de dégager le matériau dans la région des bras d'isolement et dans les régions séparant les détecteurs entre eux.

Ces deux modes de réalisation conduisent avantageusement à un composant optimisé en termes de signal sur bruit.

Il est entendu que les dispositifs bolométriques conformes à l'invention peuvent comprendre une pluralité de capteurs sous la forme d'un réseau matriciel de pixels. Un tel réseau de capteurs peut être connecté par exemple à une matrice CCD ou CMOS. Avec un système d'imagerie approprié, le dispositif de l'invention constitue alors une caméra infrarouge.

Les dispositifs bolométriques de l'invention peuvent également être intégrés dans des structures dites monolithiques, fabriquées de manière collective par les procédés de micro-électronique qui ont été développés pour le silicium.

Ainsi, des imageurs infrarouges monolithiques, fonctionnant à température ambiante, peuvent être fabriqués en connectant directement une matrice d'éléments sensibles à un circuit de multiplexage de type CMOS ou CCD. Le substrat support peut être constitué d'un circuit électronique intégré comprenant d'une part des dispositifs de stimulis et de lecture et d'autre part les composants de multiplexage qui permettent de sérialiser les signaux issus des différents détecteurs et de les transmettre vers un nombre réduit de sorties pour être exploités par un système d'imagerie usuelle.

Dans de tels dispositifs, les supports isolants sont réalisés sous forme de couches minces ayant par exemple une épaisseur de 5 à 100 nm. Ces éléments isolants (par exemple SiN, SiO, ZnS, etc.) sont obtenus à l'aide des techniques de dépôt à basse température habituellement utilisées pour ces matériaux, telles que la pulvérisation cathodique ou le dépôt chimique en phase vapeur assisté plasma (PECVD). La gravure de ces matériaux est généralement réalisée par des procédés d'attaque chimique assistée par plasma.

Les matériaux métalliques constituant les électrodes (par exemple Ti, TiN, Pt, etc.) sont préférentiellement déposés par pulvérisation cathodique. La forme des électrodes est définie par des procédés de gravure chimique ou par plasma. L'épaisseur des électrodes est comprise par exemple entre 5 nm et 100 nm. Les électrodes qui se prolongent dans les bras d'isolement sont connectées à l'étage d'entrée du circuit de lecture par des procédés classiques de reprise de contact, et sont adaptées à la structure du micro-pont (analogue aux points d'ancrage 11 de la figure 2).

Le matériau est déposé sous l'aspect d'une couche mince selon l'invention, à l'aide d'une des techniques décrites précédemment Sa gravure peut être réalisée par voie chimique (HCl, $H_3PO_4$) ou par des procédés de gravure plasma spécifiques, ou encore par usinage ionique.

L'invention concerne également un procédé de détection d'un rayonnement infrarouge ou de production d'imagerie infrarouge, à l'aide d'un dispositif bolométrique capable d'absorber un rayonnement incident, de le convertir en chaleur, et de communiquer une partie de la chaleur produite à un élément sensible dont la résistivité varie avec la température, dans lequel ledit dispositif est tel que défini précédemment.

Le dispositif de l'invention est utilisable dans de nombreux domaines d'application, par exemple dans le domaine militaire (dispositifs de visée et d'exploration nocturne), dans le domaine industriel (contrôle de pièces), dans le domaine de la sécurité (détection d'incendies, repérage de victimes dans des pièces enfumées, surveillance nocturne des sites, assistance à la conduite nocturne de véhicules), ou dans le domaine médical (cartographie de circulation sanguine, mammographie, etc.).

Les exemples et figures qui suivent sont présentés à titre illustratif et non limitatif du domaine de l'invention.

- la figure 1 représente les variations de la résistivité et de $\alpha$ de la couche mince décrite à l'exemple 1, en fonction de la température du traitement thermique oxydant, et de l'épaisseur,
- la figure 2 représente schématiquement une vue en perspective simplifiée d'un mode de réalisation d'un dispositif bolométrique selon l'invention,
- la figure 3 illustre deux variantes d'intégration d'une couche mince du matériau selon l'invention dans un dispositif bolométrique selon l'invention.

## Exemple 1 : Couches minces de magnétite Fe$_3$O$_4$

On prépare des particules de magnétite $Fe_3O_4$ par précipitation d'hydroxydes de fer en milieu basique. La solution comportant le précipité est maintenue sous balayage d'air à 70 °C pendant quatre jours. L'oxyde $Fe_3O_4$ se forme progressivement par oxydation et déshydratation des hydroxydes initiaux. Après avoir lavé et séché le précipité, on effectue un chamottage des particules à 900 °C sous atmosphère d'azote pour diminuer leur surface spécifique.

A l'issue de ce traitement, on mélange la poudre à un liant organique (alcool polyvinylique) dans les proportions suivantes (en masse) : 80% de magnétite, 16% d'eau, 4% d'alcool polyvinylique. On effectue ensuite le pressage de la poudre sous une pression de 55 tonnes dans une matrice de 10cm à l'aide d'une presse hydraulique. Le compact cru obtenu est densifiée par frittage à 950 °C sous atmosphère d'azote pour éviter la formation de l'oxyde $\alpha$- $Fe_2O_3$.

L'élaboration de la couche mince est effectuée avec un bâti de pulvérisation cathodique de type SCM400 (Alcatel CIT), fonctionnant en mode radio-fréquence. Le substrat est du silicium recouvert d'une couche de $SiO_2$ de 1 $\mu$m d'épaisseur. Le dépôt de ferrite est effectué dans les conditions citées ci-après:

- Plasma d'argon
- Pression d'enceinte: 0,5 Pa
- Distance cible-substrat: 5 cm
- Densité de puissance RF: 3,1 W/cm$^2$
- Sans magnétron
- Vitesse de dépôt: 4.5 nm/min

Les épaisseurs voulues sont obtenues en faisant varier les temps de dépôt :

|  | Exemple 1a | Exemple 1b |
|---|---|---|
| Epaisseur (nm) | 50 | 100 |
| Résistivité (Ohm.cm) | 0,012 | 0,021 |
| Alpha (%.K$^{-1}$) | -1,2 | -1,2 |

- Exemple 1a, épaisseur = 50 nm, temps de dépôt =11 minutes,
- Exemple 1b, épaisseur =100 nm, temps de dépôt = 22 minutes.

L'analyse radiocristallographique montre que les couches minces sont constituées d'une phase spinelle pure $Fe_3O_4$. Les propriétés électriques des films à l'état brut de dépôt sont les suivantes:

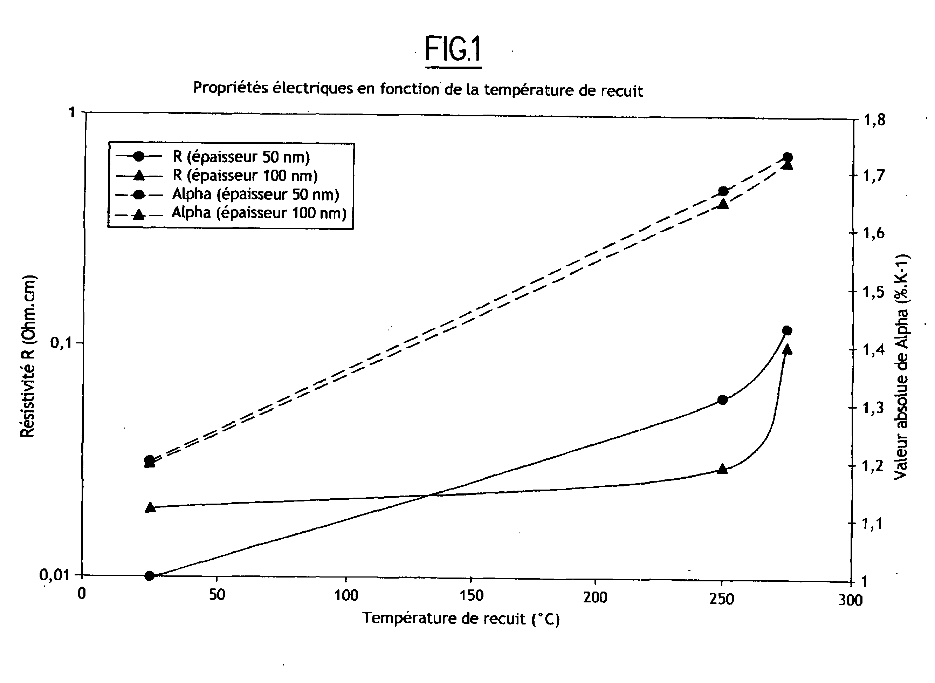

On modifie les propriétés électriques par des traitements thermiques sous air (durée du traitement : 2 heures) permettant de modifier le taux de lacunes cationiques dans la structure spinelle. Les résultats sont représentés à la figure 1, qui montre que de tels traitements d'oxydation permettent d'améliorer la sensibilité $\alpha$.

## Exemple 2 : Couches minces de magnétite $Fe_3O_{4+\delta}$

On prépare des couches minces de magnétite $Fe_3O_4$ par une méthode analogue à celle décrite dans l'exemple 1. Les substrats sont identiques, mais les conditions de dépôt diffèrent, et sont les suivantes :

- Plasma d'argon
- Pression d'enceinte: 2 Pa
- Distance cible-substrat: 5 cm
- Densité de puissance RF : 0,75 W/cm$^2$
- Avec magnétron
- Epaisseur du dépôt : 100 nm

L'analyse radiocristallographique montre que les couches minces sont constituées d'une phase spinelle pure $Fe_3O_4$. Un échantillon est gardé à l'état brut de dépôt (Exemple 2a) tandis que deux autres sont traités sous air respectivement à 175 °C (Exemple 2b) et 250 °C (Exemple 2c) pendant 2 heures de manière à, former $Fe_3O_{4+\delta}$.

Les propriétés électriques des films sont les suivantes :

|  | Exemple 2a | Exemple 2b | Exemple 2c |
|---|---|---|---|
| Traitement | Brut | 175 °C | 250 °C |
| Résistivité (Ohm.cm) | 1,6 | 27,6 | 715 |
| Alpha (%.K$^{-1}$) | -1,9 | -3,9 | -4,5 |

## Exemple 3 : Couches minces de $Fe_{1.25}Co_{0.67}Cu_{0.27}Mn_{0.81}O_{4+\delta}$

La poudre de ferrite est obtenue par co-précipitation d'hydroxydes à partir de nitrates de cobalt, cuivre, manganèse et fer précipités dans la triéthylamine. Le procédé d'obtention de la cible frittée est analogue à celui de l'exemple 1. La température de frittage est de 900 °C.

Les couches minces sont déposées sur un substrat de verre de 1,2 mm d'épaisseur. Les conditions de dépôt sont les suivantes :

- Plasma d'argon
- Pression d'enceinte: 0,5 Pa
- Distance cible-substrat: 5 cm
- Densité de puissance RF : 2 W/cm$^2$
- Avec magnétron
- Epaisseur du dépôt : 300 nm

Après traitement thermique sous air à 300 °C pendant 2 heures, les propriétés électriques du film sont les suivantes :

- Résistivité = 1150 Ohm.cm,
- Alpha = -2,7 %.K$^{-1}$

## Exemple 4 : Couches minces de $Fe_{2.4}Co_{0.3}Zn_{0.3}O_4$

Les quantités appropriées d'oxydes (0,11 mole ZnO ; 0,11 mole CuO et 0,44 mole de $Fe_2O_3$) sont mélangées et finement broyées. La poudre est chamottée à 750 °C. Le procédé d'obtention de la cible frittée est analogue à celui de l'exemple 1. La température de frittage est de 900 °C.

Les couches minces sont déposées sur un substrat de verre de 1,2 mm d'épaisseur. Les conditions de dépôt sont les suivantes:

- Plasma d'argon
- Pression d'enceinte: 0,5 Pa
- Distance cible-substrat: 5,5 cm
- Densité de puissance RF : 2,75 W/cm$^2$
- Sans magnétron
- Epaisseur du dépôt: 125 nm.

Les propriétés électriques du film à l'état brut de dépôt sont les suivantes :

- Résistivité = 0,28 Ohm.cm,
- Alpha = -1,1 %.K$^{-1}$

**Revendications**

1. Utilisation comme matériau sensible en couche mince pour la détection bolométrique de radiations infrarouges, d'un matériau ayant une structure de ferrite spinelle dont la composition chimique, en dehors d'agents dopants éventuellement présents, répond à la formule brute I :

$$Fe_{3-(x+y)}M_xA_yO_{4+\delta} \qquad (I)$$

dans laquelle le fer est l'élément métallique majoritaire,
M représente un métal ou une combinaison de deux ou plusieurs métaux de transition autres que le fer, M étant choisi parmi Co, Cu, Mn, Ni, Zn et Ti ou une de leurs combinaisons,
A représente au moins un métal choisi parmi le magnésium et l'aluminium,
les métaux et l'oxygène sont sous forme d'ions,
x représente le nombre d'ions métalliques M, identiques ou différents,
y représente le nombre d'ions métalliques A,
x peut varier de 0 à 2, et quelque soit x, x < 3-x-y
y peut varier de 0 à 0,5,
et
δ représente 0 ou un nombre positif, suffisamment faible pour que le produit de formule I contienne au moins un métal présent sous forme d'ions ayant deux états d'oxydation différents et situés sur un même sous-réseau de la structure spinelle,

les agents dopants éventuellement présents étant présents sous forme d'oxydes dans une proportion pondérale ne dépassant pas 1 à 2 % en poids, par rapport au poids de l'oxyde spinelle, et choisis parmi le silicium, le phosphore, le bore, des métaux alcalino-terreux, en particulier Ca, Ba, Sr, des métaux alcalins, par exemple Na, K, Li, le gallium, le germanium, l'arsenic, l'indium, l'antimoine, le bismuth, le plomb.

2. Dispositif bolométrique pour la détection d'un rayonnement infrarouge ou pour l'imagerie infrarouge, comprenant au moins un capteur muni d'un élément sensible ayant la forme d'une couche mince telle que définie en revendication 1.

3. Dispositif bolométrique selon la revendication 2, dans lequel ledit capteur, inséré dans un boîtier comportant une fenêtre d'entrée transparente à l'infrarouge, comprend une membrane capable d'absorber un rayonnement infrarouge et de le convertir en chaleur, ladite membrane étant disposée de façon à pouvoir être exposée à un rayonnement infrarouge incident ayant traversé la fenêtre d'entrée, et de façon à transmettre une partie de la chaleur ainsi produite audit élément sensible.

4. Dispositif selon la revendication 2 ou 3, comprenant une pluralité desdits capteurs sous la forme d'un réseau de pixels.

5. Dispositif selon la revendication 4, dans lequel ledit réseau est connecté à une matrice CCD ou CMOS.

6. Procédé de détection d'un rayonnement infrarouge ou de production d'imagerie infrarouge, à l'aide d'un dispositif bolométrique capable d'absorber un rayonnement incident, de le convertir en chaleur, et de communiquer une partie de la chaleur produite à un élément sensible dont la résistivité varie avec la température, dans lequel ledit dispositif est tel que défini dans l'une quelconque des revendications 2 à 5.

## Patentansprüche

1. Verwendung, als empfindliches Dünnschichtmaterial zur bolometrischen Detektion von Infrarotstrahlungen, eines Materials mit einer Spinell-Ferrit-Struktur, dessen chemische Zusammensetzung, abgesehen von unter Umständen vorhandenen Dotierungsstoffen, der groben Formel I entspricht:

$$Fe_{3-(x+y)} M_x A_y O_{4+\delta} \qquad (I),$$

in der das Eisen das Hauptmetallelement ist,
M für ein Metall oder eine Kombination von zwei oder mehreren Übergangsmetallen außer Eisen steht, wobei M aus Co, Cu, Mn, Ni, Zn und Ti oder einer ihrer Kombinationen ausgewählt wird,
A für mindestens ein aus Magnesium und Aluminium ausgewähltes Metall steht,
die Metalle und der Sauerstoff in Form von Ionen vorliegen,
$x$ für die Anzahl von metallischen M-Ionen, gleicher oder verschiedener Art, steht,
$y$ für die Anzahl von metallischen A-Ionen steht,
$x$ zwischen 0 und 2 variieren kann und für jedes $x$ gilt: $x < 3-x-y$,
$y$ zwischen 0 und 0,5 variieren kann, und
$\delta$ 0 oder eine positive Zahl ist, niedrig genug, dass das Produkt der Formel I mindestens ein Metall enthält, das in Form von Ionen vorliegt, die zwei verschiedene Oxidationszustände aufweisen und auf einem gleichen Untergitter der Spinellstruktur angeordnet sind,
wobei die gegebenenfalls vorhandenen Dotierungsstoffe in Form von Oxiden zu einem Gewichtsanteil, der bezüglich des Gewichts des Spinell-Oxids nicht 1 bis 2 Gewichts-% überschreitet, vorliegen und aus Silicium, Phosphor, Bohr, alkalischen Erdmetallen, insbesondere Ca, Ba, Sr, Alkalimetallen, z.B. Na, K, Li, Gallium, Germanium, Arsen, Indium, Antimon, Bismut, Blei ausgewählt sind.

2. Bolometrische Vorrichtung zur Detektion von Infrarotstrahlung oder zur Infrarotbildgebung, umfassend mindestens einen Sensor, der mit einem empfindlichen Element in Dünnschichtform, wie es in Anspruch 1 definiert ist, ausgestattet ist.

3. Bolometrische Vorrichtung nach Anspruch 2, in der der Sensor, der in ein Gehäuse eingefügt ist, das ein infrarottransparentes Eingangsfenster aufweist, eine Membran aufweist, die Infrarotstrahlung absorbieren und sie in Wärme umwandeln kann, wobei die Membran so angeordnet ist, dass sie einer das Eingangsfenster durchlaufenden inzidenten Infrarotstrahlung ausgesetzt ist und sie ein Teil der so erzeugten Wärme an das empfindliche Element übertragen kann.

**4.** Vorrichtung nach Anspruch 2 oder 3, umfassend mehrere Sensoren in Form einer Pixelanordnung.

**5.** Vorrichtung nach Anspruch 4, in der die Anordnung mit einer CCD- oder CMOS-Matrix verbunden ist.

**6.** Verfahren zur Detektion von Infrarotstrahlung oder zur Erzeugung von Infrarotbildern mithilfe einer bolometrischen Vorrichtung, die eine inzidente Strahlung absorbieren, sie in Wärme umwandeln und einen Teil der erzeugten Wärme an ein sensibles Element weitergeben kann, dessen Widerstand mit der Temperatur variiert, wobei die Vorrichtung derart ist, wie sie in einem der Ansprüche 2 bis 5 definiert ist.

**Claims**

**1.** Use as a sensitive material in a thin layer for bolometric detection of infrared radiation of a material having a spinel ferrite structure of chemical composition, ignoring doping agents if any are present, satisfying empirical formula I:

$$Fe_{3-(x+y)}M_xA_yO_{4+\delta} \qquad (I)$$

in which iron is the majority metallic element;
M represents a metal or a combination of two or more transition metals other than iron; M being selected from Co, Cu, Mn, Ni, Zn, and Ti, or a combination thereof,
A represents at least one metal selected from magnesium and aluminum;
the metals and the oxygen being in the form of ions;
x represents the number of metal ions M, whether identical or different metals;
y represents the number of metal ions A;
x may lie in the range 0 to 2, and whatever x, x<3-x-y,
y may lie in the range 0 to 0.5; and
$\delta$ represents 0 or a positive number that is sufficiently small for the substance of formula I to contain at least one metal present in the form of ions having two different oxidation states and situated on the same sublattice of the spinel structure, the potentially present doping agents being present in the form of oxides at a concentration by weight that does not exceed 1% to 2% by weight relative to the weight of the spinel oxide, and being selected from silicon, phosphorous, boron, alkaline-earth metals, in particular Ca, Ba, Sr, alkali metals, for example Na, K, Li, gallium, germanium, arsenic, indium, antimony, bismuth, lead.

**2.** A bolometric device for detecting infrared radiation or for infrared imaging, the device comprising at least one sensor provided with a sensitive element in the form of a thin layer as defined in claim 1.

**3.** A bolometric device according to claim 2, in which said sensor, inserted in a packet including an inlet window that is transparent to infrared, comprises a membrane capable of absorbing infrared radiation and of converting it into heat, said membrane being disposed in such a manner as to be capable of being exposed to incident infrared radiation that has passed through the inlet window, and in such a manner as to transmit a fraction of the heat produced in this way to said sensitive element.

**4.** A device according to claim 2 or claim 3, comprising a plurality of said sensors in the form of an array of pixels.

**5.** A device according to claim 4, in which said array is connected to a CCD or CMOS matrix.

**6.** A method of detecting infrared radiation or of producing infrared imaging with the help of a bolometric device capable of absorbing incident radiation, of converting it into heat, and of communicating a fraction of the heat produced to a sensitive element of resistivity that varies with temperature, in which said device is a device as defined in any one of claims 2 to 5.

# FIG.1

Propriétés électriques en fonction de la température de recuit

FIG.2

Gravure du ferrite

Réticulation

Réticulation    Gravure du ferrite    Ouverture de contact

Passivation

Ferrite

Isolant

Electrode

Isolant

Bras d'isolation thermique    Planche

## 3A

Gravure du ferrite

Passivation

Ferrite

Electrode

Isolant

Bras    Planche

## 3B

# FIG.3

## RÉFÉRENCES CITÉES DANS LA DESCRIPTION

**Documents brevets cités dans la description**

- JP 2000348905 A
- EP 1058276 A2
- US 5854587 A
- FR 2150608

**Littérature non-brevet citée dans la description**

- **A. DOCTOR ; S. BALIGA ; M. ROST.** Sputtered films thermistor IR detector. *Proc. IEEE Mohawk Valley Dual-Use Technology and Applied Conférence,* 1993, 153-156